# EUROPEAN PATENT SPECIFICATION

(11) **EP 3 888 192 B1**
(45) Date of publication and mention of the grant of the patent: **16.08.2023**
(21) Application number: 18811528.1
(22) Date of filing: 29.11.2018
(51) Int. Cl.: H01R 4/64, H01R 12/58, H01R 13/17, H05K 1/02, H05K 5/00

(54) **ELECTRIC DEVICE**
ELEKTRISCHE VORRICHTUNG
DISPOSITIF ÉLECTRIQUE

(43) Date of publication of application: 06.10.2021
(73) Proprietor: HELLA GMBH & CO. KGAA, 59552 Lippstadt (DE)
(72) Inventor: SEEBERG-ELVERFELDT, Christoph, 59558 Lippstadt (DE)
(86) International application number: PCT/EP2018/082934
(87) International publication number: WO 2020/108755

(56) References cited:
- EP-A2- 0 825 680
- US-A- 3 281 751
- US-A- 5 267 125
- US-B1- 6 308 394

## Description

The present invention relates to an electric device according to claim 1.

Electric devices, comprising a printed circuit board with an electric circuit with at least one electric component and a connector to ground, whereat said printed circuit board and said connector to ground are electrically and mechanically connected to each other via at least one connecting element, are already known in different examples, such as in document US 5,267,125.

It is an object of the invention to provide an electric device with an enhanced electrical contact between a printed circuit board and a connector to ground of said electric device.

This object of the invention is solved by an electric device according to claim 1.

A main advantage of the electric device according to the invention is, that said at least one spring pin enhances said electrical contact between said printed circuit board and said connector to ground of said electric device. Said at least one spring pin does ensure a good electrical or a good electrical and mechanical connection between said printed circuit board on one side and said connector to ground on the other side. Thus, it is possible to employ said at least one spring pin merely for electrically connecting said printed circuit board with said connector to ground or to employ said at least one spring pin for electrically and mechanically connecting said printed circuit board with said connector to ground. That means, that said at least one connecting element of the electric device may comprise only at least one spring pin for electrically and mechanically connecting said printed circuit board to said connector to ground, or may comprise at least one spring pin and at least one other type of a connecting element for electrically and mechanically connecting said printed circuit board to said connector to ground, whereat said at least one spring pin may be used for electrically or electrically and mechanically connecting said printed circuit board to said connector to ground.

Furthermore, said at least one spring pin does need less space for mounting compared to other connecting elements like screws or rivets. Therefore, it is possible to use a higher number of spring pins compared to other connecting elements. Thus, the electrical or electrical and mechanical connection between said printed circuit board and said connector to ground is further enhanced and distributed more evenly. Moreover, a surface of said printed circuit board, said electric circuit with at least one electric component is mounted to, can be used more efficiently for mounting said at least one electric component, because of less mechanical stress in the vicinity of said at least one spring pin compared to other types of connecting elements, like screws and rivets.

Further advantageous developments of the electric device according to the invention are apparent from the sub-claims as well as from the following description of an embodiment of an electric device by means of the attached Figures.

According to the invention, said at least one of said at least one spring pin is designed as a coiled spring pin. Coiled spring pins are also known as spiral pins and providing excellent performance to counter fatigue.

In general, said electric device according to the invention is advantageously usable in a great variety of different embodiments and use cases. A preferable development of the electric device according to the invention is, that said printed circuit board and said connector to ground with at least one of said at least one spring pin inserted into said corresponding pin holes of said printed circuit board and said connector to ground are building an EMC protection system for protecting at least one of said at least one electric component of said electric circuit of said printed circuit board and/or at least one electric component of another electric circuit from electromagnetic radiation. "EMC" stands for electromagnetic compatibility. EMC protection of electric components of electric circuits are quite critical for the correct function of electric components. By employing the electric device according to the invention, wherein said printed circuit board is electrically or electrically and mechanically connected to said connector to ground via at least one spring pin, an EMC protection system can be realized with less effort and in a space saving manner.

Another advantageous development of the electric device according to the invention is, that at least one contact surface of said pin hole of said printed circuit board in contact with said spring pin is electrically connected to said electric circuit of said printed circuit board and is designed as an electrically conductive coating of said printed circuit board. That way, the electrical connection between said at least one spring pin and said printed circuit board is realized quite easily. Furthermore, a good electrical contact between said at least one spring pin and said printed circuit board, even under harsh environmental conditions, is ensured.

Basically, said electrically conductive coating can be of any useful and suitable kind, shape, material, dimension, number and positioning. Advantageously, said electrically conductive coating is designed as a metallization.

A preferable development of the electric device according to the aforementioned embodiments comprising an electrically conductive coating is, that said contact surface of said pin hole of said printed circuit board is designed as an inner wall of said pin hole facing a lateral surface area of said spring pin. Hereby, a good electrical contact between said electrical circuit of said printed circuit board on the one side and said at least one spring pin on the other side is even improved.

Another advantageous development of the electric device according to the invention is, that said connector to ground is designed as a heat sink for cooling said electric component of said electric circuit of said printed circuit board. That way, said connector to ground is used in a multifunctional way. On the one hand, said connector to ground is used to connect said printed circuit board to ground. On the other hand, said connector to ground is used to cool said at least one electric component of said electric circuit of said printed circuit board.

A further advantageous development of the electric device according to the invention is, that said connector to ground is designed as a part of a housing for said printed circuit board. Analog to the aforementioned embodiment of the invention, that connector to ground is also used in a multifunctional way. On the one side, said connector to ground is used to connect said printed circuit board to ground. On the other side, said connector to ground is used to encase said at least one electric component of said electric circuit of said printed circuit board.

In general, that pin holes of said printed circuit board and said connector to ground can be of any useful and suitable kind, shape, dimension, number and positioning. An advantageous development of the electric device according to the invention is, that said pin hole of said connector to ground is designed with a first and a second section, whereat said first section is located at an end of said pin hole facing said printed circuit board and said second section is located at an end of said pin hole opposite to said end facing said printed circuit board, and whereat a diameter of said pin hole in said first section is larger than a diameter of said pin hole in said second section. Hereby, it is possible to compensate for tolerances of said printed circuit board with said at least one pin hole of said printed circuit board and said connector to ground with said at least one pin hole of said connector to ground.

Furthermore, the manufacture of said at least one pin hole of said connector to ground is simplified. For example, said first section of said at least one pin hole of said connector to ground can be designed as a chamfer and said second section of said pin hole can be designed as a hole with a constant diameter. In another embodiment, said first section can be designed as a hole with a constant diameter, too.

A very advantageous development of the electric device according to the invention is, that said printed circuit board and said connector to ground are electrically or electrically and mechanically connected to each other via multiple spring pins. That way, the electrical or electrical and mechanical connection between said printed circuit board and said connector to ground is provided on a high-quality level and is ensured even under harsh environmental conditions.

The figure is a schematic illustration of an embodiment of the electric device according to the invention, wherein only the details necessary for understanding the invention are shown.

It is shown by:

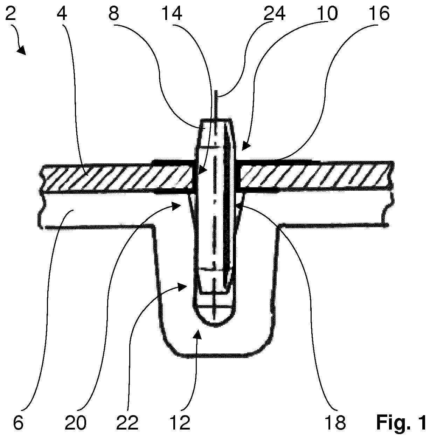

- Fig. 1: an embodiment of an electric device according to the invention in a sectional side view, partly displayed.

Fig. 1 partly displays an embodiment of an electric device 2 according to the invention. Said electric device 2 is designed as a control unit of a motor vehicle. Said motor vehicle is not displayed. Said electric device 2 comprises a printed circuit board 4 with an electric circuit. Said electric circuit is not shown and comprises at least one electric component, which is not shown, too. Furthermore, said electric device 2 comprises a connector to ground 6, whereat said printed circuit board 4 and said connector to ground 6 are electrically and mechanically connected to each other via at least one connecting element 8.

Said connector to ground 6 is designed as a part of a housing for said printed circuit board 4 and made from aluminium by aluminium die casting. Because of said connector to ground 6 is made from aluminium, said connector to ground 6 is designed as a heat sink for cooling said electric component of said electric circuit of said printed circuit board 4, too. Said connector to ground 6 according to this embodiment is a means for connecting said printed circuit board 4 with ground.

Said at least one connecting element 8 is designed as a coiled spring pin. In total, a number of ten spring pins 8 are used to electrically and mechanically connect said printed circuit board 4 to said connector to ground 6. Thus, said printed circuit board 4 and said connector to ground 6 are electrically and mechanically connected to each other via multiple spring pins 8. In Fig. 1, only one spring pin 8 is displayed. But said displayed spring pin 8 is exemplary to all of said ten spring pins 8 used according to the embodiment of Fig. 1. Thus, said printed circuit board 4 is electrically and mechanically connected to said connector to ground 6 solely by connecting elements designed as spring pins 8. Each of said spring pins 8 is inserted concurrently into a pin hole 10 of said printed circuit board 4 and into a pin hole 12 of said connector to ground 6 which correspond to said specific spring pin 8. That means, a pair of two pin holes 10, 12 correspond to each spring pin 8, thus said electric device 2 according to the embodiment comprises ten pin holes 10 of said printed circuit board 4 and ten pin holes 12 of said connector tor ground 6. Said pin holes 12 of said connector to ground 6 are designed as blind holes. Said spring pins 8 are chamfered on both ends in order to ease said insertion of said spring pins 8 into said pin holes 10, 12. See Fig. 1.

Said spring pins 8 are evenly distributed around at least one of said at least one electric component of said electric circuit of said printed circuit board 4 in order to build an EMC protection system. Thus, said printed circuit board 4 and said connector to ground 6 with said spring pins 8 inserted into said corresponding pin holes 10, 12 of said printed circuit board 4 and said connector to ground 6 are building said EMC protection system for protecting at least one of said at least one electric component of said electric circuit of said printed circuit board 4 and/or at least one electric component of another electric circuit from electromagnetic radiation.

In order to ensure a good and long-lasting electrical and mechanical connection of said printed circuit board 4 to said connector to ground 6, even under harsh environmental conditions, at least one contact surface 14 of said pin hole 10 of said printed circuit board 4 in contact with said spring pin 8 is electrically connected to said electric circuit of said printed circuit board 4 and is designed as an electrically conductive coating 16 of said printed circuit board 4. Said electrically conductive coating 16 is designed as a metallization and said contact surface 14 of each of said pin holes 10 of said printed circuit board 4 is designed as an inner wall of a specific pin hole 10 of said pin holes 10 facing a lateral surface area 18 of said spring pin 8 corresponding to said specific pin hole 10.

Basically, said pin holes 12 of said connector to ground 6 can be of any useful and suitable shape and dimension. According to the explained embodiment each of said pin holes 12 of said connector to ground 6 is designed with a first section 20 and a second section 22, whereat said first section 20 is located at an end of said pin hole 12 facing said printed circuit board 4 and said second section 22 is located at an end of said pin hole 12 opposite to said end facing said printed circuit board 4, and whereat a diameter of said pin hole 12 in said first section 20 is larger than a diameter of said pin hole 12 in said second section 22. As can be seen from Fig. 1, said first section 20 of each of said pin holes 12 of said connector to ground 6 is designed as a chamfer. Thus, said diameter of said first section 20 of each of said pin holes 12 is variable along a longitudinal axis of each of said pin holes 12. Said longitudinal axis is displayed in Fig. 1 as a chain line 24.

Now, the function of the electric device according to the embodiment is being explained using Fig. 1.

In order to assemble said printed circuit board 4 and said connector to ground 6, said printed circuit board 4 and said connector to ground 6 are joint together that way, that said pin holes 10 of said printed circuit board 4 substantially match with said pin holes 12 of said connector to ground 6. After said joining of said printed circuit board 4 with said connector to ground 6, said spring pins 8 are driven into said pin holes 10, 12. Each spring pin 8 is driven into a pair of pin holes 10, 12 of said printed circuit board 4 and said connector to ground 6 corresponding to each other. Because of said first sections 20 of said pin holes 12 of said connector to ground 6 are each designed as a chamfer, tolerances of said printed circuit board 4 and/or said connector to ground 6 can be compensated for. Furthermore, said chamfered ends of said spring pins 8 inserted into said pin holes 10 of said printed circuit board 4 and said pin holes 12 of said connector to ground 6 promote said insertion of said spring pins 8 in to said pin holes 10, 12, too.

Said electrical and mechanical connection between said printed circuit board 4 and said connector to ground 6 is achieved by said multiple spring pins 8, on the one side electrically and mechanically connected to said printed circuit board 4 via said electrically conductive coating 16, and on the other side electrically and mechanically connected to said connector to ground 6 via said second section 22 of each of said pin holes 12 of said connector to ground 6.

The electric device according to the invention can be of any useful and suitable type and is not limited to control units of motor vehicles. Furthermore, the electric device does not have to have an EMC protection system, which is built by the printed circuit board and the connector to ground with at least one of the at least one spring pin inserted into the corresponding pin holes of the printed circuit board and the connector to ground. Embodiments of an electric device according to the invention are possible, which do not have any EMC protection system or do have another kind of EMC protection system. If an EMC protection system is part of the electric device, regardless whether it is built according to claim 3 or not, the EMC protection system can be designed in order to protect at least one of the at least one electric component of the electric circuit of the printed circuit board of the electric device and/or to protect at least one electric component of another electric circuit which may be part of another electric device.

The connector to ground can be of any useful and suitable kind, function, shape, material, dimension, number and positioning, too. For example, the connector to ground can be designed merely as a connector to ground connecting the printed circuit board to ground, directly or indirectly. Thus, the connector to ground does not have to be multifunctional. Of course, in other embodiments of the invention, the connector to ground may be designed as a heat sink or as a housing. Furthermore, the heat sink and/or the housing can be of another useful and suitable design. For example, the connector to ground, merely as connector to ground or as a combination of a connection to ground and a heat sink and/or a housing, may be from a different material or a combination of materials. Moreover, the connector to ground can be of any useful and suitable material, like aluminium, any other electroconductive metal, plastic with an electroconductive coating or a composite material with electroconductive parts.

In an example not according to the invention, instead of all connecting elements being spring pins it is also possible, that at least one of the connecting elements is not designed as a spring pin. That way it would be possible, that the function of the at least one spring pin is limited to an electrical connection of the printed circuit board with the connector to ground. Thus, it is possible to employ the at least one spring pin merely for electrically connecting the printed circuit board with the connector to ground or to employ the at least one spring pin for electrically and mechanically connecting the printed circuit board with the connector to ground. That means, that the at least one connecting element of the electric device may comprise only spring pins for electrically and mechanically connecting the printed circuit board to the connector to ground, or may comprise at least one spring pin and at least one other type of a connecting element for electrically and mechanically connecting the printed circuit board to the connector to ground, whereat the at least one spring pin may be used for electrically or electrically and mechanically connecting the printed circuit board to the connector to ground.

The electrically conductive coating does not have to be designed as a metallization. Moreover, other kinds of electrical contact between the at least one spring pin and the printed circuit board are possible, too. The at least one spring pin is not limited to the number of spring pins of the explained embodiment, but can be of any useful and suitable number.

According to the invention, the pin hole of the connector to ground is designed with a first and a second section, whereat the first section is located at an end of the pin hole facing the printed circuit board and the second section is located at an end of the pin hole opposite to the end facing the printed circuit board, and whereat a diameter of the pin hole in the first section is larger than a diameter of the pin hole in the second section and constant along a longitudinal axis of the first section of the pin hole.

### List of reference numbers

- 2: Electric device
- 4: Printed circuit board
- 6: Connector to ground
- 8: Connecting element, designed as spring pin
- 10: Pin hole of printed circuit board 4
- 12: Pin hole of connector to ground 6
- 14: Contact surface of pin hole 10 with spring pin 8
- 16: Electrically conductive coating 16 of printed circuit board 4
- 18: Lateral surface area of spring pin 8
- 20: First section of pin hole 12
- 22: Second section of pin hole 12
- 24: Longitudinal axis of pin hole 12

## Claims

1. Electric device (2), comprising a printed circuit board (4) with an electric circuit with at least one electric component and a connector to ground (6), whereat said printed circuit board (4) and said connector to ground (6) are electrically and mechanically connected to each other via at least one connecting element (8),
wherein,
at least one of said at least one connecting element (8) is designed as a coiled spring pin (8), whereat said at least one coiled spring pin (8) is inserted concurrently into a pin hole (10) of said printed circuit board (4) and into a pin hole (12) of said connector to ground (6) each corresponding to said coiled spring pin (8),
wherein,
said pin hole (12) of said connector to ground (6) is designed with a first and a second section (20, 22), whereat said first section (20) is located at an end of said pin hole (12) facing said printed circuit board (4) and said second section (22) is located at an end of said pin hole (12) opposite to said end facing said printed circuit board (4), and whereat a diameter of said pin hole (12) in said first section (20) is larger than a diameter of said pin hole (12) in said second section (22).

2. Electric device (2) according to claim 1,
wherein,
at least one contact surface (14) of said pin hole (10) of said printed circuit board (4) in contact with said spring pin (8) is electrically connected to said electric circuit of said printed circuit board (4) and is designed as an electrically conductive coating (16) of said printed circuit board (4).

3. Electric device (4) according to claim 2,
wherein,
said electrically conductive coating (16) is designed as a metallization (16).

4. Electric device (2) according to claim 2 or 3,
wherein,
said contact surface (14) of said pin hole (10) of said printed circuit board (4) is designed as an inner wall of said pin hole (10) facing a lateral surface (18) area of said spring pin (8).

5. Electric device (2) according to one of the claims 1 to 4,
wherein,
said connector to ground (6) is designed as a part of a housing (6) for said printed circuit board (4).

6. Electric device (2) according to one of the claims 1 to 5,
wherein,
said printed circuit board (4) and said connector to ground (6) are electrically or electrically and mechanically connected to each other via multiple spring pins (8).

## Patentansprüche

1. Elektrische Vorrichtung (2), umfassend eine gedruckte Leiterplatte (4) mit einer elektrischen Schaltung mit mindestens einer elektrischen Komponente und einem Verbinder zu Masse (6), wobei die gedruckte Leiterplatte (4) und der Verbinder zu Masse (6) elektrisch und mechanisch über mindestens ein Verbindungselement (8) miteinander verbunden sind,
wobei
mindestens eines von dem mindestens einen Verbindungselement (8) als ein Schraubenfederstift (8) gestaltet ist, wobei der mindestens eine Schraubenfederstift (8) gleichzeitig in ein Stiftloch (10) der gedruckten Leiterplatte (4) und in ein Stiftloch (12) des Verbinders zu Masse (6) eingesetzt ist, die jeweils zu dem Schraubenfederstift (8) passen,
wobei
das Stiftloch (12) des Verbinders zu Masse (6) mit einem ersten und einem zweiten Abschnitt (20, 22) gestaltet ist, wobei der erste Abschnitt (20) an einem der gedruckten Leiterplatte (4) zugewandten Ende des Stiftlochs (12) angeordnet ist und der zweite Abschnitt (22) an einem Ende des Stiftlochs (12) angeordnet ist, das dem Ende, welches der gedruckten Leiterplatte (4) zugewandt ist, gegenüberliegt, und wobei ein Durchmesser des Stiftlochs (12) in dem ersten Abschnitt (20) größer als ein Durchmesser des Stiftlochs (12) in dem zweiten Abschnitt (22) ist.

2. Elektrische Vorrichtung (2) nach Anspruch 1,
wobei
mindestens eine in Kontakt mit dem Federstift (8) befindliche Kontaktfläche (14) des Stiftlochs (10) der gedruckten Leiterplatte (4) mit der elektrischen Schaltung der gedruckten Leiterplatte (4) elektrisch verbunden ist und als eine elektrisch leitfähige Beschichtung (16) der gedruckten Leiterplatte (4) gestaltet ist.

3. Elektrische Vorrichtung (4) nach Anspruch 2,
wobei
die elektrisch leitfähige Beschichtung (16) als eine Metallisation (16) gestaltet ist.

4. Elektrische Vorrichtung (2) nach Anspruch 2 oder 3,
wobei
die Kontaktfläche (14) des Stiftlochs (10) der gedruckten Leiterplatte (4) als eine Innenwand des Stiftlochs (10), einem Bereich einer Seitenfläche (18) des Federstifts (8) zugewandt, gestaltet ist.

5. Elektrische Vorrichtung (2) nach einem der Ansprüche 1 bis 4,
wobei
der Verbinder zu Masse (6) als ein Teil eines Gehäuses (6) für die gedruckte Leiterplatte (4) gestaltet ist.

6. Elektrische Vorrichtung (2) nach einem der Ansprüche 1 bis 5,
wobei
die gedruckte Leiterplatte (4) und der Verbinder zu Masse (6) elektrisch oder elektrisch und mechanisch über mehrere Federstifte (8) miteinander verbunden sind.

## Revendications

1. Dispositif électrique (2), comprenant une carte de circuit imprimé (4) avec un circuit électrique comportant au moins un composant électrique et un connecteur à la terre (6), ladite carte de circuit imprimé (4) et ledit connecteur à la terre (6) étant reliés électriquement et mécaniquement l'un à l'autre par l'intermédiaire d'au moins un élément de connexion (8),
dans lequel,
au moins un de ces éléments de connexion (8) est conçu comme une goupille à ressort enroulé (8), où ladite au moins une goupille à ressort enroulé (8) est insérée simultanément dans un trou de goupille (10) de ladite carte de circuit imprimé (4) et dans un trou de goupille (12) dudit connecteur à la terre (6), chacun correspondant à ladite goupille à ressort enroulé (8),
dans lequel,
ledit trou de goupille (12) dudit connecteur à la terre (6) est conçu avec une première et une seconde section (20, 22), où ladite première section (20) est située à une extrémité dudit trou de goupille (12) faisant face à ladite carte de circuit imprimé (4) et ladite seconde section (22) est située à une extrémité dudit trou de goupille (12) opposée à ladite extrémité faisant face à ladite carte de circuit imprimé (4), et où un diamètre dudit trou de goupille (12) dans ladite première section (20) est plus grand qu'un diamètre dudit trou de goupille (12) dans ladite seconde section (22).

2. Dispositif électrique (2) selon la revendication 1,
dans lequel,
au moins une surface de contact (14) dudit trou de goupille (10) de ladite carte de circuit imprimé (4) en contact avec ladite goupille à ressort (8) est électriquement connectée audit circuit électrique de ladite carte de circuit imprimé (4) et est conçue comme un revêtement électriquement conducteur (16) de ladite carte de circuit imprimé (4).

3. Dispositif électrique (4) selon la revendication 2,
dans lequel,
ledit revêtement conducteur d'électricité (16) est conçu comme une métallisation (16).

4. Dispositif électrique (2) selon la revendication 2 ou 3,
dans lequel,
ladite surface de contact (14) dudit trou de goupille (10) de ladite carte de circuit imprimé (4) est conçue comme une paroi intérieure dudit trou de goupille (10) faisant face à une surface latérale (18) de ladite goupille à ressort (8).

5. Dispositif électrique (2) selon l'une des revendications 1 à 4,
dans lequel,
ledit connecteur à la terre (6) est conçu comme une partie d'un boîtier (6) pour ladite carte de circuit imprimé (4).

6. Dispositif électrique (2) selon l'une des revendications 1 à 5,
dans lequel,
ladite carte de circuit imprimé (4) et ledit connecteur à la terre (6) sont reliés électriquement ou électriquement et mécaniquement l'un à l'autre par l'intermédiaire de plusieurs goupilles à ressort (8).
